# EUROPEAN PATENT SPECIFICATION

(11) **EP 0 564 082 B1**
(45) Date of publication and mention of the grant of the patent: **21.05.1997**
(21) Application number: 93301090.2
(22) Date of filing: 16.02.1993
(51) Int. Cl.: H01J 37/32

(54) **Plasma processing apparatus for generating uniform strip-shaped plasma**
Plasmabearbeitungsgerät zur Erzeugung eines uniformen bandförmigen plasmas
Appareil de traitement à plasma pour générer un plasma uniforme en forme de bande

(30) Priority: 30.03.1992 JP 105679/92; 28.08.1992 JP 253666/92
(43) Date of publication of application: 06.10.1993
(73) Proprietor: DAIHEN CORPORATION, Osaka-shi, Osaka 532 (JP)
(72) Inventor: Ishii, Akira, Amagasaki-shi, Hyogo 661 (JP); Minomo, Syoichiro, Takatsuki-shi, Osaka 569 (JP); Taniguchi, Michio, Kobe-shi, Hyogo 651-12 (JP); Sugiyo, Masato, Izumi-shi, Osaka 590-02 (JP)
(74) Representative: Gura, Henry Alan

(56) References cited:
- EP-A- 0 183 561
- EP-A- 0 335 675
- EP-A- 0 480 273
- GB-A- 2 110 870

## Description

The present invention relates to a plasma processing apparatus for generating a uniform strip-shaped plasma, and more particularly, to a plasma processing apparatus for performing a plasma process such as a chemical vapor deposition (CVD) process, an ashing process, a sputtering process, an etching process or the like by projecting a generated plasma onto an object to be processed, wherein the plasma is generated by supplying a microwave within a plasma chamber in which a predetermined processing gas is contained at a predetermined pressure.

Conventionally, a method of forming a diamond film on a mechanical tool, a magnetic film or the like as a protection film has been developed, and in the conventional method, a plasma is used in order to form the protection film uniformly in a high speed at a low temperature. Further, conventionally, a plasma has been used upon etching a film in one of processes for manufacturing an LSI and a liquid crystal display unit.

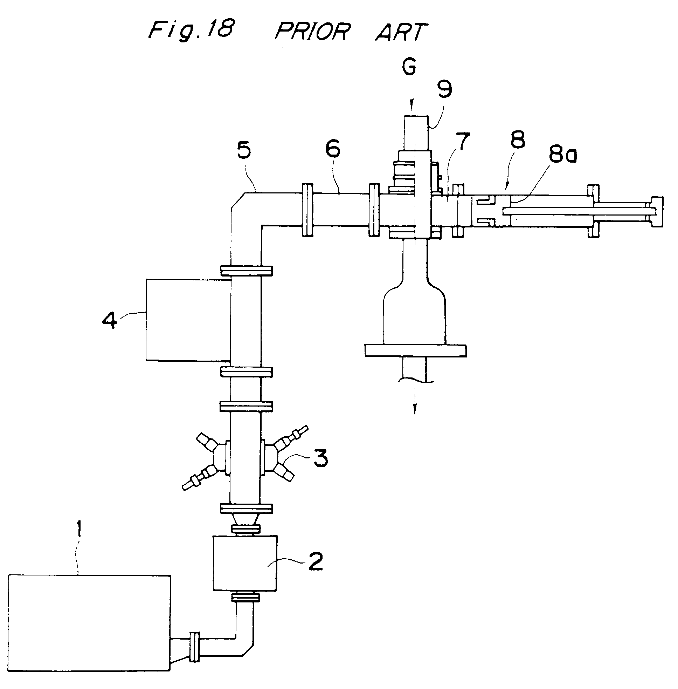

Fig. 18 shows the whole composition of a conventional plasma processing apparatus.

Referring to Fig. 18, the conventional plasma processing apparatus comprises a microwave generator 1, an isolator 2, a directional coupler 3, an impedance matching unit 4, a corner rectangular waveguide 5, rectangular waveguides 6 and 7, and a terminating unit 8 including a movable short-circuit plate 8a which are connected in series to each other, and further comprises a silica tube 9 mounted so as to pass through a through hole formed in the rectangular waveguide 7. The silica tube 9 is connected to a vacuum pump (not shown). After the vacuum pump makes the inner air of the silica tube 9 in a predetermined high vacuum state, and then a predetermined processing gas G is supplied into the silica tube 9 so that the inner pressure of the silica tube 9 becomes a predetermined pressure.

Microwave energy generated by the microwave generator 1 is supplied through the isolator 2, the directional coupler 3, the impedance matching unit 4, the corner rectangular waveguide 5 and the rectangular waveguide 6 into the rectangular waveguide 7. The microwave energy supplied within the rectangular waveguide 7 propagates through a tube wall of the silica tube 9 into a plasma chamber located within the silica tube 9, and then puts the processing gas supplied within the silica tube 9 in a plasma state so as to generate a plasma of the processing gas. An object to be processed is provided in the center of the rectangular waveguide 7 located within the silica tube 9 or on the downstream side of the generated plasma so as to be projected by the generated plasma.

Further, a plasma generating apparatus utilizing the Electron Cyclotron Resonance (ECR) (referred to as an ECR plasma generating apparatus hereinafter) has been used. In the ECR plasma generating apparatus, microwave energy is supplied into a plasma chamber through a rectangular waveguide, and an air-core coil is provided so as to surround the plasma chamber. A magnetic field generated by exciting the air-core coil and the supplied microwave lead to the ECR phenomenon, thereby generating a plasma having a high density in a high vacuum state.

In order to improve the processing efficiency in performing a plasma process such as a process of forming a thin film, etching a film or the like, it has been necessary to provide a technique or method of performing the plasma process uniformly at a high speed at a low temperature by uniformly projecting a plasma onto an object having a relatively large area to be processed. Further, in a process for manufacturing a liquid crystal display performed in a manner similar to that of the process for manufacturing an LSI, as the size of the liquid crystal display is enlarged, it has been necessary to provide a technique or method of uniformly projecting the generated plasma onto a processing surface having a relatively large area of the object to be processed.

However, in the conventional plasma generating apparatus, since there is a difference of the density of the plasma between the center of the plasma and the periphery thereof, the speed of forming a film and the etching speed at respective different parts of the object to be processed cannot be uniform, and then it is difficult to manufacture a device having good quality with higher efficiency. Further, since the cross section of the plasma is generated in a shape of circle, the plasma process can not be efficiently performed in the case where the processing surface of the object to be processed has either a rectangular shape or a square shape.

As a method of generating a plasma having a larger diameter or area in the conventional plasma processing apparatus shown in Fig.18, it could be suggested that the diameter of the silica tube 9 is enlarged. However, since the diameter of the silica tube 9 is limited by the dimension of the waveguide determined depending on the wavelength of the microwave energy used, the diameter of the silica tube 9 cannot be enlarged so as to process an enlarged object.

Further, in the ECR plasma generating apparatus, in order to enlarge the diameter of the generated plasma, it is necessary to enlarge the diameter of the air-core coil, so increasing the size of the ECR plasma generating apparatus. This increase in size can result in an ECR plasma generating apparatus that cannot be used for practical purposes.

It is also known from EP-A-183561A to provide a plasma processing apparatus comprising a plasma chamber, the interior of which is sealed from but coupled to an adjustment microwave waveguide through a transmission window in an E-plane of the waveguide, the object to be processed being placed in the chamber close to the window. Further plasma processing apparatus employing microwave energy is described in EP-A-480273A and GB-A-2110870A.

According to the present invention, there is provided a plasma processing apparatus comprising a plasma chamber having a window formed in a side wall of the chamber, within which an object to be processed can be placed so as to be close to said window, a coupling rectangular waveguide having an opening formed in an E-plane thereof, a coupling member mounted between said opening of said waveguide and said window of said plasma chamber for electromagnetically coupling said opening with said window in an airtight state, said coupling member being made of a material for propagating microwave energy, and microwave generating means, connected to said coupling rectangular waveguide, for generating and supplying microwave energy along said waveguide, thereby propagating the microwave through said opening of said waveguide, said coupling member and said window into said plasma chamber to act on the object in said chamber, the waveguide opening being in the form of a strip-shaped rectangular slit extending axially of the waveguide, the plasma chamber window having a strip-shaped rectangular form with its longer axis extending parallel to the waveguide axis, and magnetic field generating means being provided for generating a magnetic field in the path of propagation of the microwave energy from said window towards said object to be processed in the plasma chamber.

Preferably, the plasma processing apparatus further comprises distribution control means for making substantially uniform the density of microwave energy propagated through said slit of said coupling rectangular waveguide along the longitudinal direction of said slit.

For example, said distribution control means can comprise a pair of metal plates extending within said coupling rectangular waveguide perpendicular to the E-planes of the coupling rectangular waveguide and inclined with respect to the longitudinal direction of said slit of the waveguide, the angles of inclination of said pair of metal plates from the longitudinal direction of said slit being set so as to make the microwave energy propagated through said slit substantially uniform along the longitudinal direction of said slit.

In an alternative example, said distribution control means can comprise a metal plate provided within said coupling rectangular waveguide perpendicular to the E-planes of said coupling rectangular waveguide and inclined from the longitudinal direction of said slit, the angle of inclination of said metal plate from the longitudinal direction of said slit being set so as to make the microwave energy propagated through said slit substantially uniform along the longitudinal direction of said slit.

In a further example, said distribution control means comprises a metal plate provided within said coupling rectangular waveguide perpendicular to the H-planes of said coupling rectangular waveguide and inclined from the longitudinal direction of said slit, the angle of inclination of said metal plate from the longitudinal direction of said slit being set so as to make the microwave energy propagated through said slit substantially uniform along the longitudinal direction of said slit.

Plasma processing apparatus according to the invention may further comprise a branch form rectangular waveguide mounted between said microwave generating means and respective ends of said coupling rectangular waveguide to propagate the microwave energy from said microwave generating means into both said ends of said coupling rectangular waveguide.

In another form of the invention, the apparatus comprises a pair of movable connecting means movably mounted between said branch form rectangular waveguide and a respective one of said ends of said coupling rectangular waveguide so as to change the length of the waveguide path between said branch form rectangular waveguide and said ends of said coupling rectangular waveguide and thereby the phase of a standing wave generated in said coupling rectangular waveguide for generating a magnetic field in the path of propagation of the microwave energy from said window towards said object to be processed in the plasma chamber.

Apparatus according to the invention may also comprise means for generating a divergent magnetic field directed from the center of said window of said plasma chamber toward said plasma chamber.

By way of example, these and other features of the present invention will be described in more detail with reference to some preferred embodiments thereof illustrated in the accompanying drawings,throughout which like parts are designated by like reference numerals, and in which:
Fig. 1 is a top plan view showing the overall arrangement of a plasma processing apparatus in a first preferred embodiment according to the present invention;
Fig. 2 is a top plan view partially including a cross sectional view of a coupling rectangular waveguide 16 for coupling with a plasma chamber 18 and peripheral components thereof shown in Fig. 1;
Fig. 3 is a cross sectional view to a larger scale on line III - III' of Fig. 1 showing a plasma chamber 18;
Fig. 4 is a perspective view showing a structure for supporting one of a pair of metal plates of the first preferred embodiment;
Fig. 5 is a longitudinal cross sectional view of the coupling rectangular waveguide 16 of a modification of the first preferred embodiment for coupling with a plasma chamber 18 and peripheral components thereof shown in Fig. 1;
Fig. 6 is a cross sectional view to a larger scale on line III - III' of Fig. 1 showing the plasma chamber 18 and the coupling rectangular waveguide 16 of the modification shown in Fig. 5;
Fig. 7 is a longitudinal cross sectional view of the coupling rectangular waveguide 16 of another modification of the first preferred embodiment for coupling with a plasma chamber 18 and peripheral components thereof shown in Fig. 1;
Fig. 8 is a top plan view showing the overall arrangement of a plasma processing apparatus in a second preferred embodiment according to the present invention;
Fig. 9 is a top plan view to a larger scale of a movable connection section of the second preferred embodiment;
Fig. 10 is a cross sectional view to a larger scale on line VII - VII' of Fig. 8 showing the movable connection section 71;
Fig. 11 is a cross sectional view to a larger scale on line VIII - VIII' of Fig. 8 showing a coupling rectangular waveguide 54 and the plasma chamber 18;
Fig. 12 is a cross sectional view showing a magnetic field generating unit of a first modification of the preferred embodiments;
Fig. 13 is a cross sectional view showing another magnetic field generating unit of a second modification of the preferred embodiments;
Fig. 14 is a cross sectional view showing a divergent magnetic field generating unit 1 provided in the magnetic field generating unit of a first modification of the preferred embodiments;
Fig. 15 is a cross sectional view showing a divergent magnetic field generating unit provided in the magnetic field generating unit of a second modification of the preferred embodiments;
Fig. 16 is a cross sectional view showing a divergent magnetic field generating unit provided in the magnetic field generating unit of a third modification of the preferred embodiments;
Fig. 17 is a cross sectional view showing a divergent magnetic field generating unit provided in the magnetic field generating unit of a fourth modification of the preferred embodiments; and
Fig. 18 is a top plan view showing the overall arrangement of a conventional plasma processing apparatus.

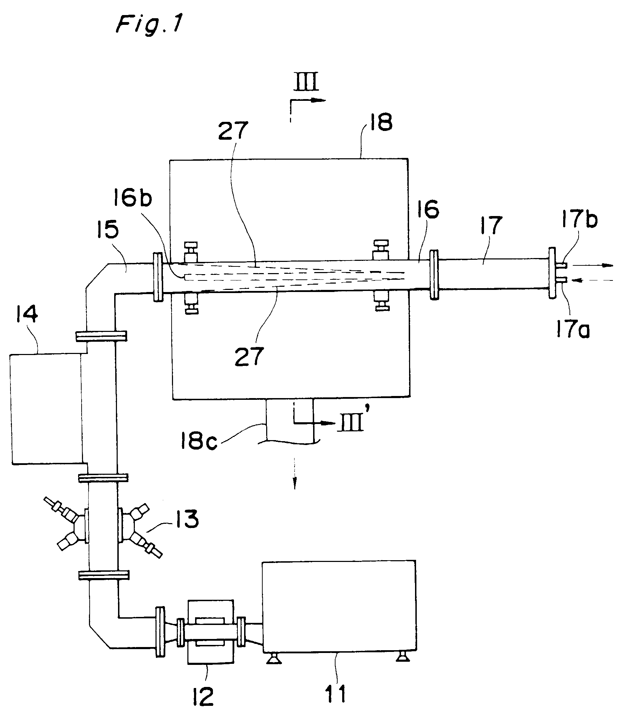

Figs. 1 to 4 show a plasma processing apparatus of a first preferred embodiment according to the present invention.

Referring to Fig. 1, the plasma processing apparatus comprises a microwave generator 11 for generating microwave energy, an output end of which is connected through an isolator 12, a directional coupler 13, an automatic impedance matching unit 14 and a corner rectangular waveguide 15 to one end of a rectangular waveguide 16 (referred to as a coupling rectangular waveguide hereinafter) for electromagnetic coupling with a plasma chamber 18. Another end of the coupling rectangular waveguide 16 is connected with a dummy load 17 for absorbing extra remaining microwave energy. The dummy load 17 has an introduction port 17a through which cooling water flows into the dummy load 17 and an exhaust port 17b through which the exhaust cooling water exits. In the dummy load 17, the extra remaining microwave energy is absorbed by the cooling water flowing through the introduction port 17a, and then the water heated by the microwave energy flows out therefrom through the exhaust port 17b.

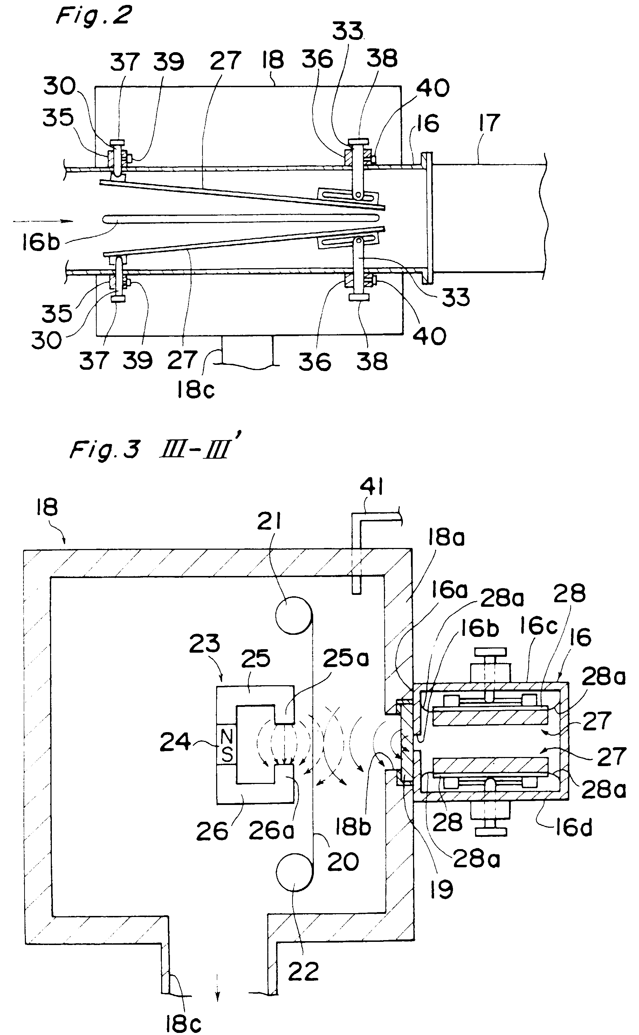

Referring to Fig. 3, the plasma chamber 18 has either a cubic shape or a rectangular parallelepiped shape, and an airtight structure, and is provided so that one side wall 18a of the plasma chamber 18 is in contact with one E-plane 16a of the rectangular waveguide 16 parallel to the E plane 16a. In the side wall 18a of the plasma chamber 18, an elongate, strip-shaped rectangular window 18b is formed so as to pass through the side wall 18a and to extend in the direction of the axis of the rectangular waveguide 16 which is parallel to the length of the window 18b. The window 18b for propagating microwave energy therethrough is made airtight with a silica glass plate 19 which is mounted in the window 18b so that an outer surface of the silica glass plate 19 is located on the same plane as an outer surface of the side wall 18a of the plasma chamber 18.

An exhaust port 18c is provided in the plasma chamber 18, and is connected with a vacuum pump (not shown). An introduction pipe 41 for a flow of a predetermined processing gas into the plasma chamber 18 is mounted on another wall of the plasma chamber 18 so as to pass through that wall in an airtight manner. Within the plasma chamber 18, a pair of opposed rollers 21 and 22 is provided, a sheet-form object 20 to be processed being wound around the roller 21 and the processed object being wound up around the roller 22. The object 20 to be processed which extends from the roller 21 toward the roller 22 is disposed opposite the window 18b, and has substantially the same width as the length of the window 18b.

Further, in the plasma chamber 18, a magnetic field generating unit 23 is provided opposite the window 18b with the object 20 between it and the window. The generating unit 23 comprises a permanent magnet 24, and a pair of C-shaped magnetic pole pieces 25 and 26, one end of each of which is connected to a respective magnetic pole N and S at the ends of the permanent magnet 24. Magnetic pole parts 25a and 26a of the other end of each of the magnetic pole pieces 25 and 26 are provided at positions that are symmetrical with respect to the object 20 to be processed corresponding to the window 18b so as to oppose each other in a direction parallel to the longitudinal direction of the object 20 to be processed.

The magnetic field generating unit 23 generates magnetic lines of force, as indicated by dotted line arrows in Fig. 3, between the magnetic pole parts 25a and 26a, thereby generating a magnetic field in the space between the object 20 to be processed and the window 18b. In order to generate the magnetic field substantially uniformly in a direction parallel to or along the length of the window 18b, the magnetic field generating unit 23 preferably has substantially the same length as the length of the window 18b, or preferably has a length slightly greater than the length of the window 18b.

This preferred embodiment is provided with the magnetic field generating unit 23 but other arrangements may be provided. For example, a substantially uniform magnetic field can be generated by a plurality of magnetic field generating units 23 arranged in series along the length of the window 18b.

In the center of the width of the coupling rectangular waveguide 16 in the E-plane direction 16a, a strip-shaped rectangular slit 16b is formed so as to extend in a direction parallel to the axis of the coupling rectangular waveguide 16, opposite the windows 18b of the plasma chamber 18. The slit 16b has substantially the same length as that of the window 18b of the plasma chamber 18, and has a width smaller than the width of the window 18b. The coupling rectangular waveguide 16 is fixedly mounted by a predetermined means so that the E-plane 16a thereof is in contact with the side wall 18a of the plasma chamber 18 and the slit 16b is in contact with the center of the window 18b of the plasma chamber 18, namely, the slit 16b is matched with the window 18b and is electromagnetically coupled with the window 18b through the silica glass plate 19. In this case, the silica glass plate 19 operates as means for electromagnetically coupling the slit 16b with the window 18b or for propagating the microwave energy therethrough.

Within the coupling rectangular waveguide 16, as shown in Figs. 2 and 3, a pair of strip-shaped rectangular electrically conductive metal plates 27 is provided opposite each other and a pair of mutually opposed H planes 16c and 16d. The metal plates 27 are inclined to the longitudinal direction of the slit 16b. Each of the metal plates 27 has a length larger than that of the slit 16b, and has a width smaller than that of either H-plane 16c and 16d of the rectangular waveguide 16.

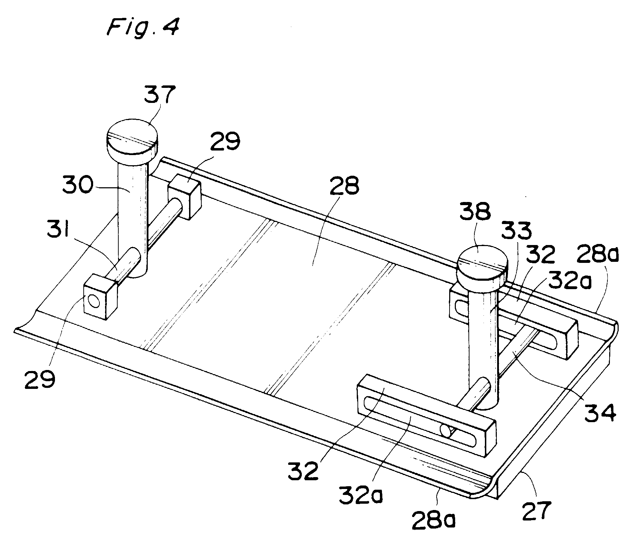

As shown in Fig. 4, each of the metal plates 27 is mounted so as to be in contact with a strip-shaped rectangular supporting plate 28 having substantially the same length as that of the metal plate, and further each metal plate and the supporting plate 28 are mounted integrally as one body on each other using a bonding agent or the like. Each supporting plate 28 is made of an electrically conductive material, and also comprises a pair of deflectable or flexible electrical conductors 28a (referred to as flexible conductors hereinafter). Each flexible conductor is made of an elastic electrically conductive material and is formed having a cross section in the form of an arc, integrally as one body with both ends in the width direction of each supporting plate 28.

Each pair of flexible conductors 28a and 28a may be connected with the ends of the width of its supporting plate 28 by a welding method or the like.

At one end in the longitudinal direction of the supporting plate 28, on the opposite side from the metal plate 27, a pair of supporting metal components 29 is fixed to the surface of the supporting plate, for example, using a bonding agent or a welding method, spaced apart in the width direction of the plate. Both ends of a pivot shaft 31 fixed to one end of the supporting shaft 30 are rotatably supported by the pair of components 29.

Further, at the other end of the supporting plate 28 from the components 29, on the opposite side from the metal plate 27, a pair of long strip-shaped supporting metal components 32 extending in the longitudinal direction of the metal plate 27 is fixed to the surface of the supporting plate using a bonding agent or a welding method. An elongate hole 32a is formed in each of the metal components 32. Both ends of a shaft 34 fixed to one end of a supporting shaft 33 are engaged in the elongate holes 32a and 32a so as to be slidably movable therein in the longitudinal direction of the supporting plate 28.

As shown in Fig. 3, the above-mentioned pair of metal plates 27 is so arranged that a pair of flexible conductors 28a formed at the both ends in the width direction of the supporting plates 28 is elastically in contact with the inner surfaces of both the E-planes of the rectangular waveguide 16, whereby each of the metal plates 27 is electrically connected through the supporting plate 28 and the flexible conductors 28a to said E-planes.

On the outer surfaces of the H-planes 16c and 16d of the coupling rectangular waveguide 16, there are fixed boss members 35 and 36 respectively for receiving the supporting shafts 30 and 33 attached on the ends of the respective supporting plates 28. Each of the supporting shafts 30 passes through a hole in the respective H-plane wall of the rectangular waveguide 16 and is engaged in a hole of the boss member 35 through which it extends, so that the shaft 30 is slidably movable in its longitudinal direction. Similarly, each of the supporting shafts 33 passes through a hole in the respective H-plane wall of the rectangular waveguide 16 and is engaged in a hole of the boss member 36 through which it extends, so that the shaft 33 is slidably movable in its longitudinal direction.

On the outer end of each of the supporting shafts 30, a stopper lug 37 is attached through a screw connection means or the like, and a stopper lug 38 is attached through a screw connection means or the like on the outer end of each of the supporting shafts 33. The amount of movement of the supporting shaft 30 into the rectangular waveguide 16 is regulated since the lug 37 is in contact with the boss member 35 when the shaft 30 is moved. Similarly, insertion of the supporting shaft 33 into the rectangular waveguide 16 is regulated by the contact of the lug 38 with the boss member 36.

Locking screws 39 for locking the movement of the supporting shafts 30 are attached to the boss members 35, and locking screws 40 for locking the movement of the supporting shafts 33 are attached to the boss members 36. By tightening the locking screws 39 and 40, the supporting shafts 30 and 33 are fixed at any position within their range of sliding movement.

The pair of metal plates 27 is provided for adjusting the power of the microwave energy propagated through respective parts of the slit 16b into the plasma chamber 18. The inclination angles of the metal plates 27 from the longitudinal direction of the slit 16b can be adjusted, by adjusting the insertion length of each of the supporting shafts 30 and 33 into the rectangular waveguide 16, to make the power of the microwave energy propagated through the slit 16b into the plasma chamber 18 substantially uniform along the length of the slit 16b.

In the case of the plasma processing apparatus shown in Figs. 1 and 2, the ends on the generator side of the metal plates 27 are located at positions close to the H-planes 16c and 16d of the rectangular waveguide 16, while the ends on the load side of the plates are located at positions close to the slit 16b. In this case, as shown in Fig. 2, the gap between the plates on the generator side of the rectangular waveguide 16 (referred to as a first gap hereinafter) and the corresponding gap on the load side of the rectangular waveguide 16 (referred to as a second gap hereinafter) are set so that the first gap is larger than the second gap.

A method of the plasma process using the plasma processing apparatus of the first preferred embodiment will be described hereinafter.

First of all, the object 20 to be processed is placed within the plasma chamber 18, and a high vacuum state is then established, the plasma chamber. Next, a chosen processing gas is supplied through the gas introduction pipe 41 into the plasma chamber 18 until the atmosphere of the plasma chamber 18 reaches a predetermined pressure.

In such a state, microwave energy is supplied from the microwave generator 11 through the isolator 12, the directional coupler 13 and the impedance matching unit 14 into one end of the coupling rectangular waveguide 16, and the energy inputted into the rectangular waveguide 16 is propagated through the slit 16b and the window 18b into the plasma chamber 18 as indicated by full lines in Fig. 3. Then, the processing gas in the plasma chamber 18 is rendered to a strip-shaped plasma state, and the plasma generated is projected onto the object 20 to perform a predetermined plasma process such as a CVD process, an ashing process, a sputtering process, an etching process or the like. The microwave energy other than that which has been propagated within the plasma chamber 18 is absorbed by the dummy load 17.

In the present preferred embodiment, since, in particular, a pair of metal plates 27 is provided within the coupling rectangular waveguide 16, the power of the microwave energy propagated through the slit 16b into the plasma chamber 18 can be made substantially uniform along the longitudinal direction of the slit 16b by adjusting the inclination angles of the metal plates 27 from the longitudinal direction of the slit 16b of the coupling rectangular waveguide 16. Therefore, the strip-shaped plasma be made substantially uniform so that its density can be uniform along the length of the window 18b and the generated plasma can then be projected uniformly onto respective parts of the object 20 to be processed. In the present preferred embodiment, there is provided a pair of metal plates 27, but, the present invention is not so limited and in another embodiment only one of metal plates 27 may be provided.

When the pair of metal plates 27 is provided within the rectangular waveguide 16 as described above so that the first gap is smaller than the second gap, almost all of the microwave energy inputted into the coupling rectangular waveguide 16 is divided between the outer sides of both metal plates. However, when, as shown in Figs. 1 and 2, the metal plates 27 are set so that the ends on the generator side of the coupling rectangular waveguide 16 are positioned close to the H-planes of the coupling rectangular waveguide 16, so that the first gap is larger than the second gap, almost all of the inputted microwave energy can be propagated into the space of the first gap (referred to as a first gap space hereinafter) between the ends of the metal plates on the generator side. As a result, almost all of the microwave energy inputted into the first gap space can flow through the slit 16b into the plasma chamber 18.

In the first preferred embodiment, a pair of metal plates 27 is provided as means for making substantially uniform the power of the microwave energy propagated through the slit 16b into the plasma chamber 18 along the length of the slit 16b. However, the present invention is not limited to this, there may be alternative provisions for making said propagated energy substantially uniform. For example, the following modifications of the first preferred embodiment may be provided.

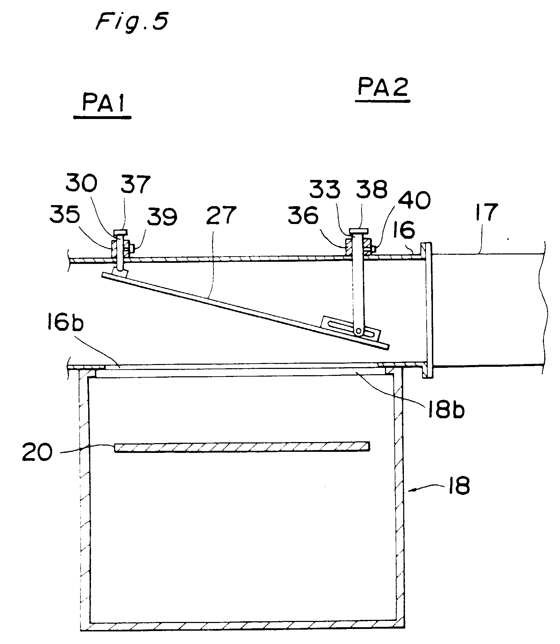

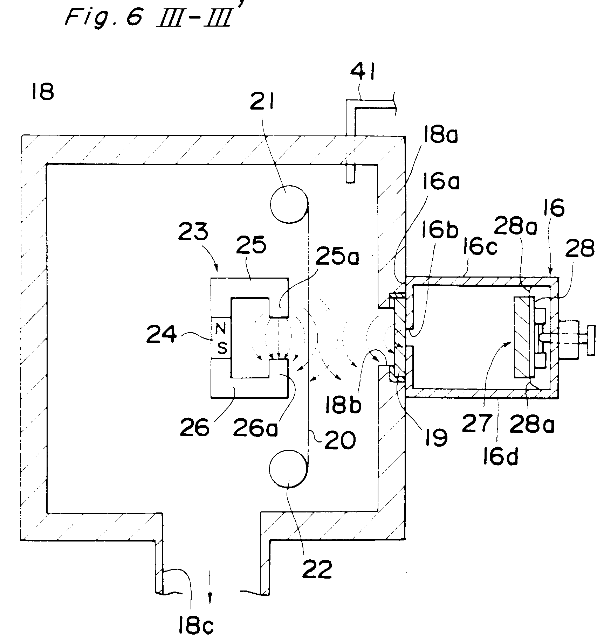

Fig. 5 shows a modified rectangular waveguide 16 for coupling with a plasma chamber 18 and peripheral components thereof shown in Fig. 1, and Fig. 6 is an enlarged cross section view equivalent to that on line III - III' of Fig. 1 showing the plasma chamber 18 and the coupling rectangular waveguide 16 of the modification shown in Fig. 5.

Referring to Figs. 4 and 5, a metal plate 27 is provided within the coupling rectangular waveguide 16 opposite the E-plane 16a and mounted in another E-plane so as to be inclined with a predetermined inclination angle from the longitudinal direction of the slit 16b of the coupling rectangular waveguide 16, using two sets of position adjustment mechanisms PA1 and PA2 respectively comprising the supporting shafts 30 and 33, the boss members 35 and 36, the stopper lugs 37 and 38, and the locking screws 39 and 40, in a manner similar to that of the first preferred embodiment. The metal plate 27 is electrically connected through the supporting plate 28 and the flexible conductors 28a to the both the H-planes 16c and 16d of the rectangular waveguide 16. It is noted that the metal plate 27 and these mounting members for the metal plate 27 are made of the same materials as those of the first preferred embodiment.

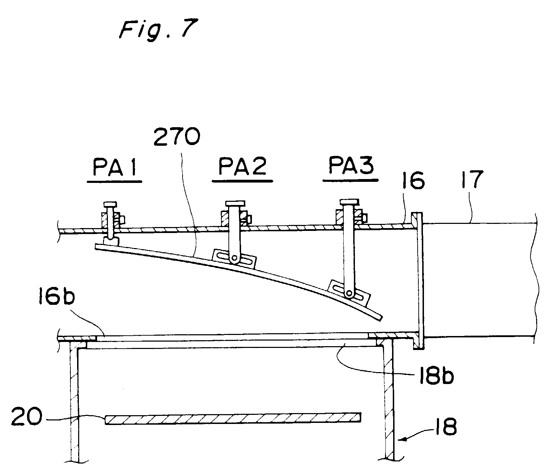

The cross section in the longitudinal direction of the metal plate or plates 27 may be curved. For example, as shown in Fig. 7, a flexible metal plate 270 may be substituted. In this case, the flexible metal plate 270 is mounted in the coupling rectangular waveguide 16 through at least three sets of position adjustment mechanisms PA1 to PA3 so that its cross section in the longitudinal direction can be given different curved shapes. The distribution of the plasma can be adjusted thereby in various ways.

In the first preferred embodiment, since a strip-shaped plasma is generated along the length of the window 18b of the plasma chamber 18, the generated plasma can be projected onto parts of almost all of the width of an object 20 having a relatively large area to be processed. Further, since the object 20 is moved in a direction perpendicular to the longitudinal direction of the slit 16b so as to be wound up by the wound-up roller 22, the plasma process can be performed continuously on the object.

In the present preferred embodiment, the object 20 to be processed has a shape of sheet, however, the present invention is not limited to this.

Further, since the magnetic field is generated between the object 20 and the window 18b by the magnetic field generating unit 23, charged particles of the generated plasma are acted on by the magnetic field to move in a spiral or screw path. This results in accelerating ionization of the processing gas, and heightening the density of the plasma which is projected onto the object 20.

Furthermore, when the intensity of the magnetic field generated by the magnetic field generating unit 23 is adjusted so that the ECR phenomenon is caused in the space between the object 20 and the window 18b, the density of the plasma can be remarkably heightened.

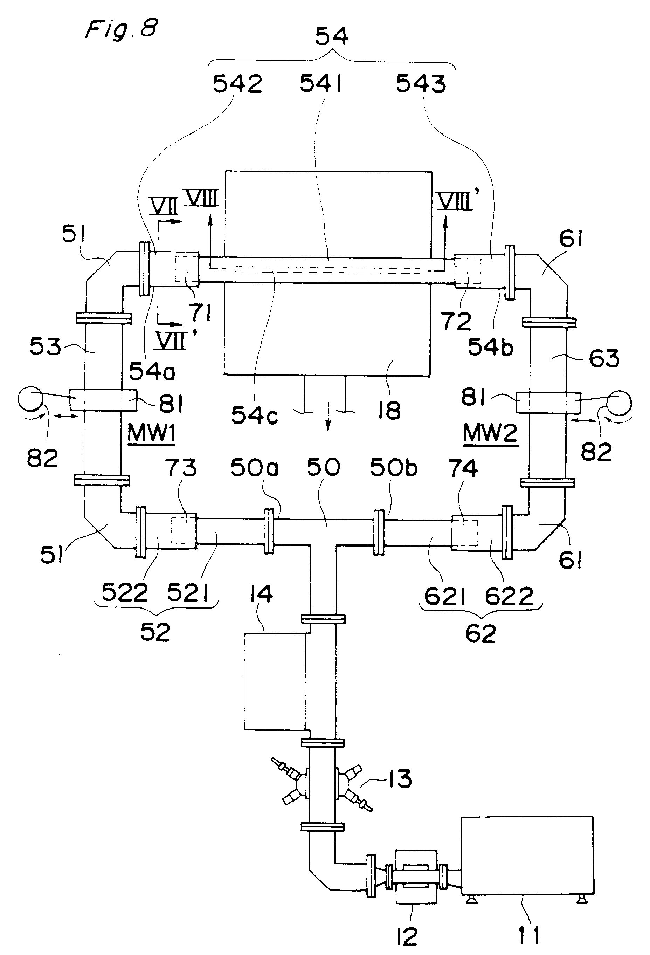

Fig. 8 shows the overall layout of a plasma processing apparatus of a second preferred embodiment according to the present invention. The same components as those shown in Fig. 1 are designated by the same numerals.

Referring to Fig. 8, the microwave generator 11 is connected in series through the isolator 12, the directional coupler 13 and the impedance matching unit 14 to a branch T type rectangular waveguide 50. One branch end 50a of the waveguide 50 is connected in series through corner rectangular waveguides 51 and rectangular waveguides 52 and 53 to one end 54a of a coupling rectangular waveguide 54 for electromagnetic coupling with the plasma chamber 18. Another branch end 50b of the waveguide 50 is similarly connected in series through corner rectangular waveguides 61 and rectangular waveguides 62 and 63 to the other end 54b of the coupling rectangular waveguide 54.

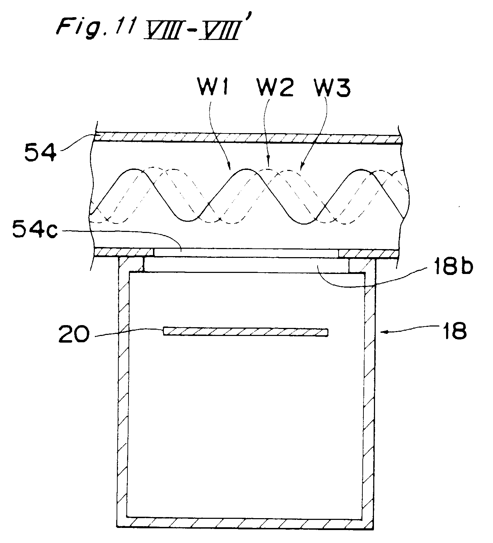

The coupling rectangular waveguide 54 having a slit 54c formed in a manner similar to that of the slit 16b of the first preferred embodiment is fixed so that the slit 54c is in contact with and extends along the center of a rectangular-shaped window 18b (Fig 11) formed like a long strip in the plasma chamber 18. In the plasma chamber 18, there are provided in a manner similar to that of the first preferred embodiment, the exhaust port 18c, the processing gas introduction pipe 41, the pair of rollers 21 and 22 for the object 20 to be processed, and the magnetic field generating unit 23.

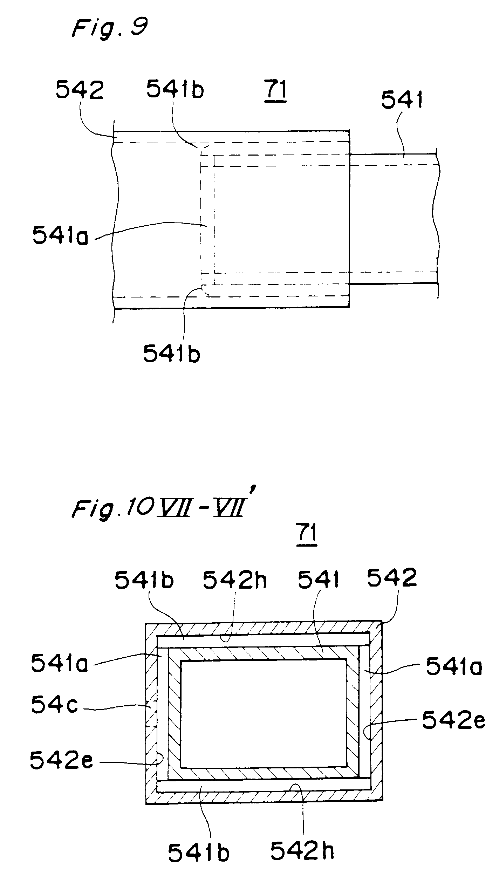

In both ends of the coupling rectangular waveguide 54 and of the rectangular waveguides 52 and 62, connection sections 71, 72, 73 and 74 are mounted so as to be movable axially of their respective waveguides, and a pair of rectangular waveguides of each of the movable connection sections 71 to 74 are engaged in each other so as to be slidably movable as shown in Fig. 9 in each of the connection sections.

For example, as shown in Fig. 9, the movable connection section 71 located at the one end of the coupling rectangular waveguide 54 comprises an inner fixed rectangular waveguide 541 and an outer movable rectangular waveguide 542 which are engaged in each other so that one end of the inner waveguide 541 is inserted into one end of the outer waveguide 542. In the movable connection section 71, arc-shaped flexible electrical conductors 541a, 541a, 541b and 541b are integrally formed as one body at all the peripheries or all the sides of the end of the inner fixed waveguide 541, and are mounted so as to be in elastic contact with both the inner E-planes 542e and 542e and both the inner H-planes 542h and 542h of the outer movable waveguide 542. Thereby, the inner and outer waveguides 541 and 542 of the movable connection section 71 are electrically connected to each other through their respective E-planes and H-planes. In a manner similar to that of the movable connection section 71, as shown in Fig. 8,
(a) the movable connection section 72 comprises an inner fixed rectangular waveguide 541 and an outer movable rectangular waveguide 543 which are electrically connected to each other through flexible electrical conductors;
(b) the movable connection section 73 comprises an inner fixed rectangular waveguide 521 and an outer movable rectangular waveguide 522 which are electrically connected to each other through flexible electrical conductors; and
(c) the movable connection section 74 comprises an inner fixed rectangular waveguide 621 and an outer movable rectangular waveguide 622 which are electrically connected to each other through flexible electrical conauctors.

In the plasma processing apparatus of the second preferred embodiment constituted as described above, if (a) a movable waveguide section MW1 comprising the two corner rectangular waveguides 51, the rectangular waveguide 53 and the movable rectangular waveguides 522 and 542 and (b) another movable waveguide section MW2 comprising the two corner rectangular waveguides 61, the rectangular waveguide 63 and the movable rectangular waveguides 543 and 622, are moved forward or backward in the axial direction of the rectangular waveguides 52, 62 and 54, the length of the waveguide path can be changed. That is, the phase of the standing wave generated in the longitudinal direction of the slit 54c within the coupling rectangular waveguide 54 can be adjusted to be set to any value.

It is necessary to move both the movable waveguide sections MW1 and MW2 by the same movement length as each other in the same direction, parallel to the axis of the rectangular waveguides 52, 62 and 54. After adjusting the length of the waveguide path in the sections MW1 and MW2 they can be fixed by a predetermined means.

Drivers 82 for driving crank mechanisms connected to respective supporting components 81 which are mounted on the rectangular waveguides 53 and 63 of the movable waveguide sections MW1 and MW2 are moved so as to interlock with a coordinated operation in synchronism with each other, and then the above-mentioned length can be continuously changed forward or backward with respect to a reference position as time passes.

In the case of a plasma process using the apparatus of the second preferred embodiment, a chosen processing gas is supplied into the plasma chamber 18 until the inner air of the plasma chamber 18 reaches a predetermined pressure. Thereafter, when microwave energy generated by the microwave generator 11 is supplied through both the branch ends 50a and 50b of the branch T type rectangular waveguide 50 and both the ends 54a and 54b of the coupling rectangular waveguide 54 into the coupling rectangular waveguide 54, a standing wave is generated within the coupling rectangular waveguide 54 as indicated by a full line W1 shown in Fig. 11 due to interference between the energy waves supplied from both directions or both ends 54a and 54b of the coupling rectangular waveguide 54. The microwave energy propagates through the slit 54c into the plasma chamber 18, and in this case the density of the strip-shaped plasma generated between the slit 54c and the object 20 to be processed becomes non-uniform in the axial direction of the coupling rectangular waveguide 54, depending on the waveform of the standing wave. However, since the degree of the non-uniformity is made less in such a process by virtue of the diffusion of the plasma being projected onto the object 20 to be processed, where appropriate the generated plasma can then be projected onto the object 20 substantially uniformly, thereby performing a predetermined plasma process more efficiently at high speed.

In one particular procedure using the second preferred embodiment, since the movable connection sections 71, 72, 73 and 74 are provided between the microwave generator 11 and the plasma chamber 18 they can be moved so as to change the phase of the standing wave, for example, to set it to various alternative standing waves W2, W3, ... as indicated by dotted lines shown in Fig. 11, the generated plasma can be projected more uniformly onto the object 20 having any width to be processed.

Further, when these movable connection sections 71 to 74 are moved to interlock forward or backward from a reference position in synchronism with each other in the axial direction of the rectangular waveguides thereof, the phase of the standing wave is shifted along the longitudinal direction of the slit 54c, and then for example, there are generated the various standing waves W1, W2, W3, W2, W1, W2, .... This results in that the time-average density of the plasma across the width of the object 20 to be processed can be made uniform, and then the generated plasma can be projected onto respective parts of the object 20 to be processed more uniformly.

In the above preferred embodiments, there is provided the magnetic field generating unit 23 for generating the magnetic field in the space between the object 20 to be processed and the window 18b, but the present invention is not limited to this. As alternative examples, the following magnetic field generating units 23a and 23b may be used.

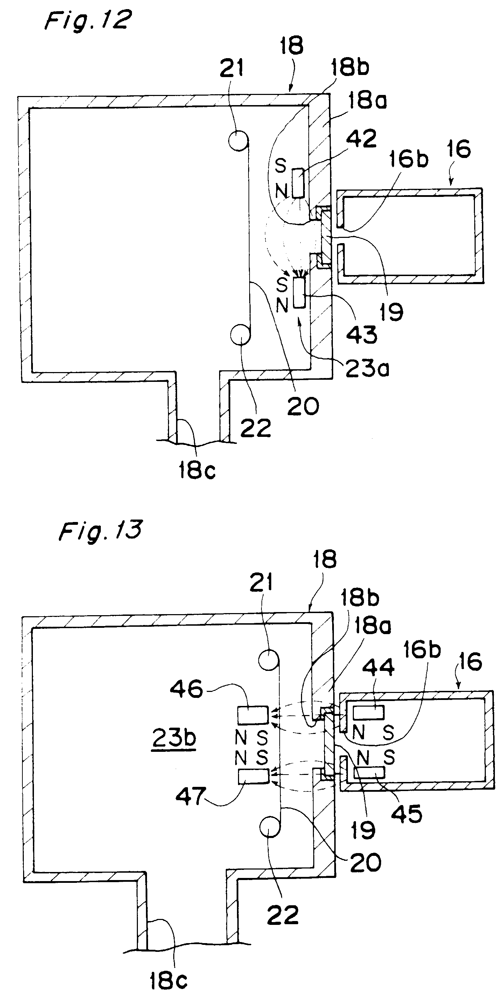

Fig. 12 shows the magnetic field generating unit 23a of a first modification which is applied to the first preferred embodiment.

Referring to Fig. 12, the magnetic field generating unit 23a comprises a pair of permanent magnets 42 and 43 located on both sides of the shorter axis of the window 18b within the plasma chamber 18 so that the N pole of the magnet 42 and the S pole of the magnet 43 or opposite each other. Magnetic lines of force are generated from the N pole of the magnet 42 to the S pole of the magnet 43 in the space between the object 20 to be processed and the window 18b. Each of the magnets 42 and 43 preferably has substantially the same length as the length of the longer axis of the window 18b, or has a length slightly longer than that of the window 18b.

In this case, the substantially uniform magnetic field can be generated along the length of the window 18b.

Further, a plurality of pairs of magnets 42 and 43 may be provided at intervals along the length of the window 18b.

Fig. 13 shows another magnetic field generating unit 23b of a second modification which is applied to the first preferred embodiment.

Referring to Fig. 13, the magnetic field generating unit 23b comprises a pair of permanent magnets 44 and 45 within the coupling rectangular waveguide 16 so as to be located on both sides of the slit 16b, and a further pair of permanent magnets 46 and 47 in a space on the opposite side of the object 20 within the plasma chamber 18 and opposed to the respective magnets 44 and 45. In this case, both pairs of magnets 44 and 45, 46 and 47 are magnetized in the same direction. Magnetic lines of force are generated in directions from the N pole of the magnet 44 toward the S pole of the magnet 46, and from the N pole of the magnet 45 toward the S pole of the magnet 47.

Each of the magnets 44 to 47 preferably has substantially the same length as the length in the longer axis direction of the slit 16b and the window 18b, or has a greater length than that of the slit 16b and the window 18b.

In this case, the substantially more uniform magnetic field can be generated along the length of the window 18b.

Further, a plurality of sets of a pair of magnets 44 and 45 and a pair of magnets 46 and 47 may be provided at intervals along the length of the window 18b.

In the above-mentioned preferred embodiments and the modifications thereof, each of the magnetic field generating units 23, 23a and 23b is positioned so that the microwave energy propagates through the window 18b into the plasma chamber 18 and from an area having a weak magnetic field toward another area having a strong magnetic field. However, each of the magnetic field generating units 23, 23a and 23b is preferably positioned so that the microwave energy propagates from an area having a strong magnetic field toward another area having a weak magnetic field.

There may be separately provided another divergent magnetic field generating unit for generating a divergent magnetic field so that the magnetic field is generated toward the plasma chamber 18 in the center in the width direction of the window 18b of the plasma chamber 18. In that case the plasma can be further projected onto the object 20 to be processed.

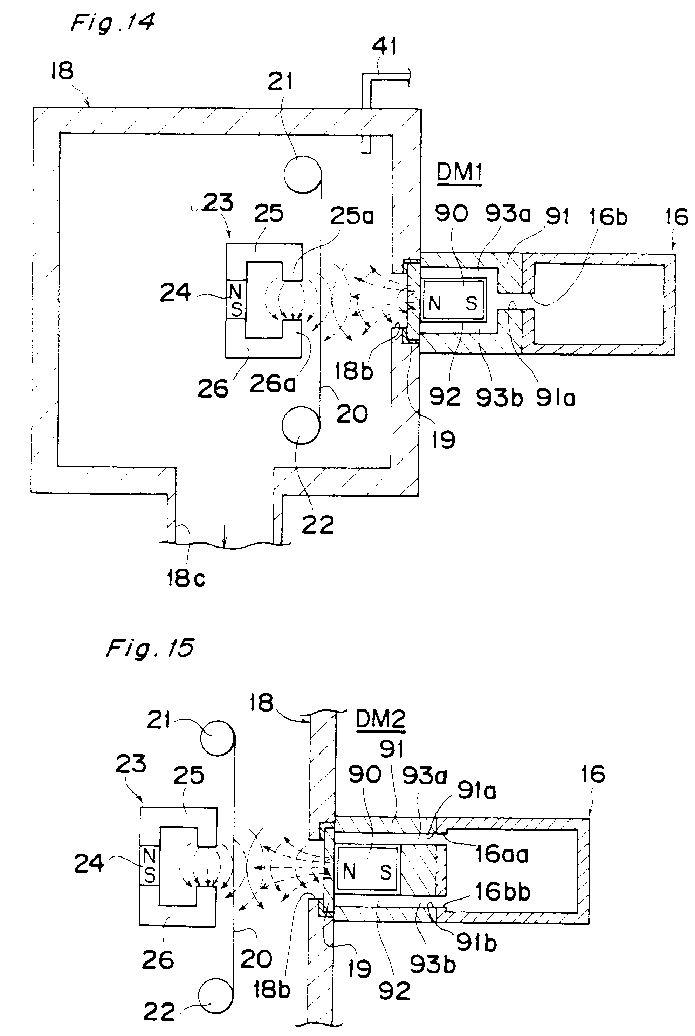

Fig. 14 is a cross sectional view of a divergent magnetic field generating unit DM1 of this type as an addition to the magnetic field generating unit 23 of a first modification which is applied to the first preferred embodiment.

Referring to Fig. 14, the divergent magnetic field generating unit DM1 is provided between the rectangular waveguide 16 and the plasma chamber 18. The generating unit DM1 comprises a permanent magnet 90 provided as a divergent magnetic field generating means, and a rectangular-cylinder-shaped electrically conductive container 91 of Al, Cu or a stainless alloy for forming a waveguide path for propagating the microwave around the outer peripheral surface of the permanent magnet 90. In the center of the width on the waveguide 16 at the side adjoining the container 91, a slit 91a having the same dimensions as those of the slit 16b is formed so as to extend in the axial direction of the coupling rectangular waveguide 16, and is further positioned so that both the slits 16b and 91a lie opposite and parallel to each other, whereby the two slits 16b and 91a form a waveguide path for passing microwave energy therethrough. The container 91 is fixed and mounted between the plasma chamber 18 and the coupling rectangular waveguide 16 by a predetermined means.

The permanent magnet 90 is positioned so that the central axis of the N and S poles thereof coincides with the center of the width of the window 18b of the plasma chamber 18, and for example, the N pole confronts the plasma chamber 18 through the center of the width of the window 18b, thereby generating a divergent magnetic field in a direction from the center of the width of the window toward the plasma chamber as indicated by dotted lines. Further, the whole surface of the permanent magnet 90 in the longitudinal direction is covered with an electrically conductive thin plate 92. The permanent magnet 90 is fixedly mounted within the container 91 so as to form waveguide paths 93a and 93b, each being a space having the same length as the length of the slit 91a, and extending from the slit 91a toward the plasma chamber 18. The container 91 is fixed and mounted between the plasma chamber 18 and the coupling rectangular waveguide 16 as described above.

On the sides of the plasma chamber 18 the ends of the two waveguide paths 93a and 93b come onto the outer surface of the silica glass plate 19. Therefore, the microwave energy propagated within the coupling rectangular waveguide 16 passes through the slits 16b and 91a and the two waveguides 93a and 93b into the plasma chamber 18, namely, the microwave energy propagates from the window 18b into the plasma chamber 18, i.e., from an area having a strong magnetic field toward another area having a weak magnetic field as indicated by full lines in Fig. 14.

Fig. 15 shows a divergent magnetic field generating unit DM2 as an addition to the magnetic field generating unit 23 of a second modification which is applied to the first preferred embodiment.

As shown in Fig. 15, there may be further provided two slits 16aa and 16bb and the slits 91a and 91b, corresponding to the above-mentioned two waveguide paths 93a and 93b, these slits propagate the microwave energy inputted into the coupling rectangular waveguide 16 to the two waveguides 93a and 93b.

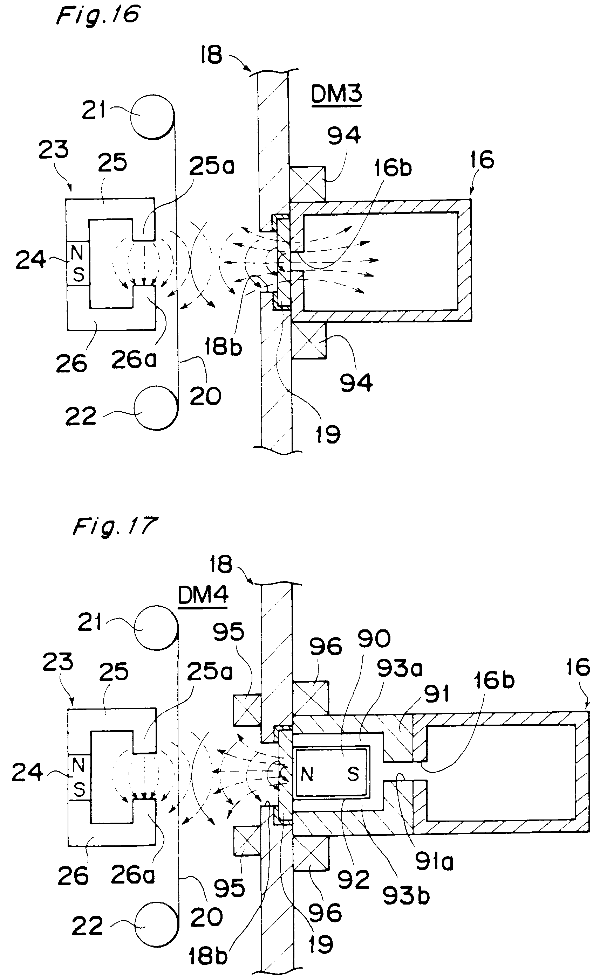

Fig. 16 shows a divergent magnetic field generating unit DM3 as an addition to the magnetic field generating unit 23 of a third modification which is applied to the first preferred embodiment.

As shown in Fig. 16, as the divergent magnetic field generating unit DM3, there may be provided an electromagnet 94 on the outer face of the coupling rectangular waveguide 16 so as to be close to the slit 16b of the waveguide. The electromagnet 94 generates a divergent magnetic field as indicated by dotted lines in Fig. 16.

Fig. 17 shows a divergent magnetic field generating unit DM4 as an addition to the magnetic field generating unit 23 in a fourth modification applied to the first preferred embodiment.

As shown in Fig. 17, in addition to the above-mentioned permanent magnet 90 operating as the divergent magnetic field generating means DM1, there may be further provided the divergent magnetic field generating means DM4 comprising electromagnets 95 and 96, wherein the electromagnet 95 is mounted within the plasma chamber 18 so as to be close to the window 18b, and the electromagnet 96 is mounted on the outer peripheral surface of the container 91 so as to be close to the plasma chamber 18. In this case, the shape of the divergent magnetic field can be controlled by changing the current flowing into the electromagnets 95 and 96.

It is possible to operate with either one or other of the electromagnets 95 and 96, or both the electromagnets may be provided.

In the above-mentioned preferred embodiments and the modifications thereof, the divergent magnetic field generating unit is used together with the above-mentioned magnetic field generating unit. However, the present invention is not limited to this. If there is obtained a predetermined desirable intensity of the magnetic field, there may be used only the divergent magnetic field generating unit without using the magnetic field generating unit.

In the above-mentioned preferred embodiments and the modifications thereof, each of the above-mentioned magnetic field generating units 23, 23a and 23b comprises a permanent magnet or permanent magnets. However, the present invention is not limited to this. There may be used an electromagnet or electromagnets instead of the permanent magnet or magnets. In particular, when providing the permanent magnet or magnets within the plasma chamber 18, generally speaking, the intensity of the magnetic field is lowered due to heat. This can be prevented by providing instead the electromagnet or electromagnets within the plasma chamber 18.

In the first preferred embodiment, the silica glass plate 19 is attached and mounted in an airtight manner in the window 18b of the plasma chamber 18, and then the coupling part between the slit 16b of the coupling rectangular waveguide 16 and the window 18b of the plasma chamber 18 is made airtight, but the present invention is not limited to this. For example, the silica glass plate 19 may be mounted on the coupling rectangular waveguide 16 so as to close the slit 16b, and the E-plane 16a of the coupling rectangular waveguide 16 on which the slit 16b is formed may be connected in an airtight manner onto the side wall 18a of the plasma chamber 18 in which the window 18b is formed. In the case where the silica glass plate 19 is mounted so as to be adjacent to the inner wall of the plasma chamber 18 the generated plasma does not flow into the propagation path of the microwave energy, so preventing the propagation of the microwave energy from being interrupted. Therefore, the energy can be inputted into the plasma chamber 18 more efficiently.

Furthermore, instead of the silica glass plate 19, there may be a plate of another material capable of propagating microwave energy, in other words, which does not absorb the energy.

According to the preferred embodiments of the present invention, there can be obtained the following advantageous effects.
(1) Because the slit 16b is formed in the E-plane of the coupling rectangular waveguide 16 and is connected onto the window 18b of the plasma chamber 18, the microwave energy is propagated through the slit 16b into the plasma window 18b, resulting in generation of a strip-shaped plasma along the length of the window 18b. In this case, the plasma can be projected over substantially all the length of a rectangular processing surface of the object 20 to be processed having a relatively large area, thereby performing the plasma process more efficiently.
(2) According to the first preferred embodiment, the power of the microwave energy propagating from one end of the coupling rectangular waveguide 16 through the slit 16b within the plasma chamber 18 can be made substantially uniform along the longitudinal direction of the slit 16b, and then the densities of the respective parts of the strip-shaped plasma generated can be made substantially uniform.
(3) According to the second preferred embodiment, the power of the microwave energy propagating from both ends of the coupling rectangular waveguide 54 through the slit 54c within the plasma chamber 18 can be made substantially uniform along the longitudinal direction of the slit 54c, and then the densities of the respective parts of the generated strip-shaped plasma can be made substantially uniform, improving the efficiency of the microwave energy power supply into the plasma chamber 18.
(4) According to the second preferred embodiment, the phase of the standing wave generated within the coupling rectangular waveguide 54 is continuously shifted forward or backward. In this case, the time-average density of the plasma in the width direction of the object 20 to be processed can be made uniform, improving the efficiency in supplying the power of the microwave energy into the plasma chamber 18.
(5) According to each of the preferred embodiments, the magnetic field is generated in a space or on a microwave propagation path between the object 20 to be processed and the window 18b. Therefore, the density of the generated plasma projected onto the object 20 can be increased, and the efficiency of the plasma process on the object 20 can be increased.
(6) According to some of the preferred embodiments, of the present invention, by providing one of the divergent magnetic field generating units DM1, DM2, DM3 and DM4, the density of the plasma can be remarkably increased.

Although the present invention has been fully described in connection with the preferred embodiments thereof with reference to the accompanying drawings, it is to be noted that various changes and modifications are apparent within the scope of the claims to those skilled in the art.

## Claims

1. A plasma processing apparatus comprising:
a plasma chamber (18) having a window (18b) formed in a side wall (18a) of the chamber (18), within which an object (20) to be processed can be placed so as to be close to said window (18b);
a coupling rectangular waveguide (16,54) having an opening (16b,54c) formed in an E-plane thereof;
a coupling member (19), mounted between said opening (16b,54c) of said waveguide (16,54) and said window (18b) of said plasma chamber (18) for electromagnetically coupling said opening (16b,54c) with said window (18b) in an airtight state, said coupling member (19) being made of a material for propagating microwave energy; and
microwave generating means (11), connected to said coupling rectangular waveguide (16,54), for generating and supplying microwave energy along said waveguide (16,54), thereby propagating the microwave through said opening (16b,54c) of said waveguide (16,54), said coupling member (19) and said window (18b) into said plasma chamber (18) to act on the object (20) in said chamber;
characterised in that
the waveguide opening (16b,54c) is in the form of a strip-shaped rectangular slit extending axially of the waveguide;
the plasma chamber window (18b) has a strip-shaped rectangular form with its longer axis extending parallel to the waveguide axis; and
magnetic field generating means (23,23a,23b) are provided for generating a magnetic field in the path of propagation of the microwave energy from said window (18b) towards said object (20) to be processed in the plasma chamber.

2. The apparatus as claimed in claim 1, further comprising distribution control means for making substantially uniform the density of microwave energy propagated through said slit (16b,54c) of said coupling rectangular waveguide (16,54) along the longitudinal direction of said slit (16b,54c).

3. The apparatus as claimed in claim 2,
wherein said distribution control means comprises a pair of metal plates (27) extending within said coupling rectangular waveguide (16,54) perpendicular to the E-planes of the coupling rectangular waveguide and inclined with respect to the longitudinal direction of said slit (16b,54c) of the waveguide, and
the angles of inclination of said pair of metal plates (27,27) from the longitudinal direction of said slit (16b,54c) are set so as to make the microwave energy propagated through said slit (16b,54c) substantially uniform along the longitudinal direction of said slit (16b,54c).

4. The apparatus as claimed in claim 2,
wherein said distribution control means comprises a metal plate (27) provided within said coupling rectangular waveguide (16,54) perpendicular to the E-planes of said coupling rectangular waveguide and inclined from the longitudinal direction of said slit (16b,54c), and
the angle of inclination of said metal plate (27) from the longitudinal direction of said slit (16b,54c) is set so as to make the microwave energy propagated through said slit (16b,54c) substantially uniform along the longitudinal direction of said slit (16b,54c).

5. The apparatus as claimed in claim 2,
wherein said distribution control means comprises a metal plate (27,270) provided within said coupling rectangular waveguide (16,54) perpendicular to the H-planes of said coupling rectangular waveguide and inclined from the longitudinal direction of said slit (16b,54c), and
the angle of inclination of said metal plate (27,270) from the longitudinal direction of said slit (16b,54c) is set so as to make the microwave energy propagated through said slit (16b,54c) substantially uniform along the longitudinal direction of said slit (16b,54c).

6. The apparatus as claimed in any one of claims 1 to 5, further comprising a branch form rectangular waveguide (50) mounted between said microwave generating means (11) and respective ends of said coupling rectangular waveguide to propagate the microwave energy from said microwave generating means (11) into both said ends of said coupling rectangular waveguide (16,54).

7. The apparatus as claimed in claim 6, further comprising a pair of movable connecting means (MW1,MW2) movably mounted between said branch form rectangular waveguide (50) and a respective one of said ends of said coupling rectangular waveguide (54) so as to change the length of the waveguide path between said branch form rectangular waveguide (50) and said ends of said coupling rectangular waveguide (54) and thereby the phase of a standing wave generated in said coupling rectangular waveguide (54) for generating a magnetic field in the path of propagation of the microwave energy from said window (18b) towards said object (20) to be processed in the plasma chamber.

8. The apparatus as claimed in any one of the preceding claims further comprising means (DM1,DM2,DM3,DM4) for generating a divergent magnetic field directed from the center of said window (18b) of said plasma chamber (18) toward said plasma chamber (18).

## Patentansprüche

1. Plasma-Bearbeitungsvorrichtung, aufweisend:
eine Plasmakammer (18) mit einem Fenster (18b), das in einer Seitenwand (18a) der Kammer (18) gebildet ist, in der ein zu bearbeitender Gegenstand (20) aufgestellt werden kann, um nahe des Fensters (18b) zu sein;
einen koppelnden, rechtwinkligen Wellenleiter (16, 54) mit einer Öffnung (16b, 54c), die in einer E-Ebene von ihm gebildet ist;
ein Kopplungselement (19), das angebracht ist zwischen der Öffnung (16b, 54c) des Wellenleiters (16, 54) und dem Fenster (18b) der Plasmakammer (18) zum elektromagnetischen Koppeln der Öffnung (16b, 54c) mit dem Fenster (18b) in einem luftdichten Zustand, wobei das Kopplungselement (19) gemacht ist aus einem Material zum Ausbreiten von Mikrowellenenergie; und
eine Mikrowellen-Erzeugungseinrichtung (11), die mit dem koppelnden, rechtwinkligen Wellenleiter (16, 54) verbunden ist, um Mikrowellenenergie längs des Wellenleiters (16, 54) zu erzeugen und zuzuführen, wodurch die Mikrowelle durch die Öffnung (16b, 54c) des Wellenleiters (16, 54), das Kopplungselement (19) und das Fenster (18b) in die Plasmakammer (18) hinein ausgebreitet wird, um auf den Gegenstand (20) in der Kammer einzuwirken;
dadurch gekennzeichnet, daß
die Wellenleiteröffnung (16b, 54c) in der Form eines streifenförmigen, rechtwinkligen Schlitzes ist, der sich axial zum Wellenleiter erstreckt;
das Plasmakammerfenster (18b) eine streifenförmige, rechtwinklige Form hat, wobei seine längere Achse sich parallel zu der Wellenleiterachse erstreckt; und
Magnetfeld-Erzeugungseinrichtungen (23, 23a, 23b) vorgesehen sind zum Erzeugen eines Magnetfeldes in dem Pfad der Ausbreitung der Mikrowellenenergie von dem Fenster (18b) zu dem zu bearbeitenden Gegenstand (20) in der Plasmakammer.

2. Vorrichtung nach Anspruch 1, ferner aufweisend eine Verteilungs-Steuereinrichtung, um die Dichte der Mikrowellenenergie, die durch den Schlitz (16b, 54c) des koppelnden, rechtwinkligen Wellenleiters (16, 54) längs der Längsrichtung des Schlitzes (16b, 54c) ausgebreitet ist, im wesentlichen gleichförmig zu machen.

3. Vorrichtung nach Anspruch 2, wobei die Verteilungs-Steuereinrichtung ein Paar von Metallplatten (27) aufweist, die sich in dem koppelnden, rechtwinkligen Wellenleiter (16, 54) senkrecht zu den E-Ebenen des koppelnden, rechtwinkligen Wellenleiters erstrecken und bezüglich der Längsrichtung des Schlitzes (16b, 54c) des Wellenleiters geneigt sind, und die Neigungswinkel des Paares von Metallplatten (27, 27) gegenüber der Längsrichtung des Schlitzes (16b, 54c) so eingestellt sind, daß sie die Mikrowellenenergie, die durch den Schlitz (16b, 54c) weitergeleitet wurde, im wesentlichen gleichförmig längs der Längsrichtung des Schlitzes (16b, 54c) machen.

4. Vorrichtung nach Anspruch 2, wobei die Verteilungs-Steuereinrichtung aufweist eine Metallplatte (27), die vorgesehen ist in dem koppelnden, rechtwinkligen Wellenleiter (16, 54) senkrecht zu den E-Ebenen des koppelnden, rechtwinkligen Wellenleiters und geneigt ist gegenüber der Längsrichtung des Schlitzes (16b, 54c), und wobei der Neigungswinkel der Metallplatte (27) gegenüber der Längsrichtung des Schlitzes (16b, 54c) so eingestellt ist, daß er die Mikrowellenenergie, die durch den Schlitz (16b, 54c) weitergeleitet bzw. ausgebreitet wurde, im wesentlichen gleichförmig längs der Längsrichtung des Schlitzes (16b, 54c) macht.

5. Vorrichtung nach Anspruch 2, wobei die Verteilungs-Steuereinrichtung eine Metallplatte (27, 270) aufweist, die in dem koppelnden, rechtwinkligen Wellenleiter (16, 54) senkrecht zu den H-Ebenen des koppelnden, rechtwinkligen Wellenleiters vorgesehen ist und gegenüber der Längsrichtung des Schlitzes (16b, 54c) geneigt ist, und wobei der Neigungswinkel der Metallplatte (27, 270) gegenüber der Längsrichtung des Schlitzes (16b, 54c) so eingestellt ist, daß er die Mikrowellenenergie, die weitergeleitet bzw. ausgebreitet ist, durch den Schlitz (16b, 54c), im wesentlichen gleichförmig macht längs der Längsrichtung des Schlitzes (16b, 54c).

6. Vorrichtung nach einem der Ansprüche 1 bis 5, ferner aufweisend einen verzweigungsform-rechtwinkligen Wellenleiter (50), der angebracht ist zwischen der Mikrowellen-Erzeugungseinrichtung (11) und jeweiligen Enden des koppelnden, rechtwinkligen Wellenleiters, um die Mikrowellenenergie von der Mikrowellen-Erzeugungseinrichtung (11) in beide Enden des koppelnden, rechtwinkligen Wellenleiters (16, 54) weiterzuleiten.

7. Vorrichtung nach Anspruch 6, ferner aufweisend ein Paar von beweglichen Verbindungseinrichtungen (MW1, MW2), die beweglich angebracht sind zwischen dem verzweigungsform-rechtwinkligen Wellenleiter (50) und einem jeweiligen Ende des koppelnden, rechtwinkligen Wellenleiters (54), um die Länge des Wellenleiterpfades zwischen dem verzweigungsform-rechtwinkligen Wellenleiter (50) und den Enden des koppelnden, rechtwinkligen Wellenleiters (54) zu ändern, und dadurch die Phase einer stehenden Welle, die erzeugt ist in dem koppelnden, rechtwinkligen Wellenleiter (54) zum Erzeugen eines Magnetfeldes in dem Pfad der Ausbreitung der Mikrowellenenergie von dem Fenster (18b) zu dem zu bearbeitenden Gegenstand (20) in der Plasmakammer.

8. Vorrichtung nach einem der vorhergehenden Ansprüche, ferner aufweisend eine Einrichtung (DM1, DM2, DM3, DM4) zum Erzeugen eines divergenten Magnetfeldes, gerichtet von der Mitte des Fensters (18b) der Plasmakammer (18) zu der Plasmakammer (18).

## Revendications

1. Dispositif de traitement par plasma comprenant :
- une chambre à plasma (18) possédant une fenêtre (18b) formée dans une paroi latérale (18a) de la chambre (18) dans laquelle un objet (20) à traiter peut être placé de façon proche de ladite fenêtre (18b);
- un guide d'onde rectangulaire de couplage (16, 54) ayant une ouverture (16b, 54c) formée dans son plan E;
- une pièce de couplage (19) montée entre ladite ouverture (16b, 54c) dudit guide d'onde rectangulaire de couplage (16, 54) et ladite fenêtre (18b) de ladite chambre à plasma (18) pour un couplage électromagnétique de ladite ouverture (16b, 54c) avec ladite fenêtre (18b) d'une façon étanche à l'air, ladite pièce de couplage (19) étant réalisé en un matériau de propagation de l'énergie de micro-ondes; et
- un moyen de génération de micro-ondes (11) raccordé audit guide d'onde rectangulaire de couplage (16, 54) pour la génération et la fourniture d'une énergie de micro-ondes le long dudit guide d'onde rectangulaire de couplage (16, 54), propageant ainsi les micro-ondes à travers ladite ouverture (16b, 54c) dudit guide d'onde rectangulaire de couplage (16, 54), ladite pièce de couplage (19) et ladite fenêtre (18b) dans ladite chambre à plasma (18) pour agir sur l'objet (20) dans ladite chambre;
dispositif caractérisé en ce que :
- l'ouverture de guide d'onde (16b, 54c) est sous la forme d'une fente rectangulaire en bande s'étendant axialement au guide d'onde;
- la fenêtre de chambre à plasma (18b) possède une forme rectangulaire en bande avec son plus grand axe s'étendant parallèle à l'axe de guide d'onde; et
- des moyens de génération de champ magnétique (23, 23a, 23b) sont prévus pour générer un champ magnétique dans le circuit de propagation de l'énergie de micro-ondes de ladite fenêtre (18b) vers ledit objet (20) à traiter dans la chambre à plasma.

2. Dispositif selon la revendication 1, comprenant, de plus, un moyen de commande de répartition pour rendre pratiquement uniforme la densité d'énergie de micro-ondes se propageant par ladite fente (16b, 54c) dudit guide d'onde rectangulaire de couplage (16, 54) selon la direction longitudinale de ladite fente (16b, 54c).

3. Dispositif selon la revendication 2, dans lequel ledit moyen de commande de répartition comprend une paire de plaques de métal (27) s'étendant dans ledit guide d'onde rectangulaire de couplage (16, 54) de façon normale aux plans E du guide d'onde rectangulaire de couplage (16, 54) et inclinées par rapport à la direction longitudinale de ladite fente (16b, 54c) du guide d'onde rectangulaire de couplage (16, 54), et les angles d'inclinaison de ladite paire de plaques de métal (27, 27) par rapport à la direction longitudinale de ladite fente (16b, 54c) sont réglés de façon à rendre pratiquement uniforme l'énergie de micro-ondes passant par ladite fente (16b, 54c) selon la direction longitudinale de ladite fente (16b, 54c).

4. Dispositif selon la revendication 2, dans lequel ledit moyen de commande de répartition comprend une plaque de métal (27) prévue dans ledit guide d'onde rectangulaire de couplage (16, 54) normale aux plans E dudit guide d'onde rectangulaire de couplage (16, 54) et inclinée par rapport à la direction longitudinale de ladite fente (16b, 54c), et l'angle d'inclinaison de ladite plaque de métal (27) par rapport à la direction longitudinale de ladite fente (16b, 54c) est réglé de façon à rendre pratiquement uniforme l'énergie de micro-ondes passant par ladite fente (16b, 54c) selon la direction longitudinale de ladite fente (16b, 54c).

5. Dispositif selon la revendication 2, dans lequel ledit moyen de commande de répartition comprend une plaque de métal (27, 270) prévue dans ledit guide d'onde rectangulaire de couplage (16, 54) normale aux plans H dudit guide d'onde rectangulaire de couplage (16, 54) et inclinée par rapport à la direction longitudinale de ladite fente (16b, 54c), et l'angle d'inclinaison de ladite plaque de métal (27, 270) par rapport à la direction longitudinale de ladite fente (16b, 54c) est réglé de façon à rendre pratiquement uniforme l'énergie de micro-ondes passant par ladite fente (16b, 54c) selon la direction longitudinale de ladite fente (16b, 54c).

6. Dispositif selon l'une quelconque des revendications 1 à 5, comprenant, de plus, un guide d'onde rectangulaire en dérivation (50) monté entre ledit moyen de génération de micro-ondes (11) et les extrémités respectives dudit guide d'onde rectangulaire de couplage (16, 54) pour propager l'énergie de micro-ondes dudit moyen de génération de micro-ondes (11) dans chacune desdites extrémités dudit guide d'onde rectangulaire de couplage (16, 54).

7. Dispositif selon la revendication 6, comprenant, de plus, une paire de moyens mobiles de raccordement (MW1, MW2) montés mobiles entre ledit guide d'onde rectangulaire en dérivation (50) et une extrémité respective desdites extrémités dudit guide d'onde rectangulaire de couplage (54) de façon à modifier la longueur dudit circuit de guide d'onde entre ledit guide d'onde rectangulaire en dérivation (50) et lesdites extrémités dudit guide d'onde rectangulaire de couplage (54) et ainsi, la phase d'une onde stationnaire générée dans ledit guide d'onde rectangulaire de couplage (54) pour générer un champ magnétique dans le circuit de propagation de l'énergie de micro-ondes à partir de ladite fenêtre (18b) vers ledit objet (20) à traiter dans la chambre à plasma.

8. Dispositif selon l'une quelconque des revendications précédentes, comprenant, de plus, des moyens (DM1, DM2, DM3, DM4) pour générer un champ magnétique divergeant dirigé du centre de ladite fenêtre (18b) de ladite chambre à plasma (18) vers ladite chambre à plasma (18).
